# EUROPEAN PATENT APPLICATION

(11) **EP 1 742 366 A1**
(43) Date of publication of application: **10.01.2007**
(21) Application number: 06253287.4
(22) Date of filing: 23.06.2006
(51) Int. Cl.: H03L 7/091, H03L 7/10, H03L 7/08, H03L 7/07

(54) **Extending lock-in range of a PLL or DLL**

(30) Priority: 23.06.2005 US 166437
(71) Applicant: QUANTUM CORPORATION, San Jose, CA 95110 (US)
(72) Inventor: Bounds, Steve, Broomfield, CO 80021 (US); Kerber, Galen G., Lafayette, CO 80026 (US); Harker, Jay, Broomfield, CO 80020 (US)
(74) Representative: Charig, Raymond Julian

(57) **Abstract**

A method, circuit and drive for improving clock recovery in clock/data signals are provided. A timing reference (255) is provided to a locking loop circuit (220), such as a PLL. The timing reference is updated based on an expectation of a frequency of a clock being recovered. A system clock (245) tracked to each clock being recovered is outputted. A current frequency of each system clock is approximated (215), and the expectation updated based on the approximated current frequency of one or more of the system clocks. If the data stream includes data separated into a series of blocks, the update may be made after an end of a block and before a beginning of a succeeding block. The approximation may be made periodically and/or numerous times for each block.

## Description

### BACKGROUND

### Field:

The present invention relates to phase lock loops (PLL) and delay locked loops (DLL), and more particularly to tuning and control of such loops.

### Description of Related Art:

A PLL/DLL (a locking loop circuit) may function to match a frequency and a phase of a generated local clock signal to a frequency and a phase of a clock detected in a received signal. The output of the generated clock can then be used for a wide variety of tasks, including recovery of data from the received signal. For example, a read head of a drive for reading a storage device may generate the received signal, and the loop may be used to output the generated clock for use in recovery of data in the received signal.

In such drives, the frequency and phase of the clock detected in the received signal may vary with time, and the locking loop circuit should be able to track those variations so that the generated clock remains in synchronization with the detected clock. For a typical locking loop circuit to successfully lock onto a frequency and phase of a detected clock, the typical locking loop circuit is provided with a reference frequency that is within a range of the frequency expected to be detected in the received signal. If the reference frequency is too far from an actual frequency of the clock in the received signal, the locking loop circuit may not achieve lock.

A measure of the ability of a locking loop circuit to achieve lock onto a clock having a frequency different from the provided reference frequency may be termed a lock-in range of the loop. Lock-in range is one design parameter of a number of design parameters for such locking loop circuit. Typically, locking loop circuit designers must balance lock-in range with these other parameters, and therefore lock-in range may be smaller than desirable. It would be beneficial to be able to extend lock-in range without redesigning a given locking loop circuit, and/or adversely impacting some of these other design parameters.

### SUMMARY

Inventive aspects include a method that comprises a step of causing provision of a timing reference to a locking loop circuit. The timing reference is for updating and/or setting based on an expectation of a frequency of a clocking signal. The method further comprises estimating a current frequency of the clocking signal, and updating the expectation of the frequency of the clocking signal based on the estimated current frequency.

Further aspects include a circuit comprising logic operable to estimate a frequency of a first system clock. The first system clock is trackable by a locking loop circuit to a clock encoded in a first signal. The locking loop circuit is operable to receive a timing reference adjustable based on an expected frequency of the clock encoded in the first signal and to determine whether a first comparison value between the frequency of the first system clock and the expected frequency exceeds a predetermined threshold. The logic is operable to provide for adjustment of the expected frequency by referencing the comparison value.

Still further aspects include a drive for reading storage media. The drive comprises one or more converters clockable by a respective system clock. The converters are for receiving a respective signal and outputting a respective quantized stream of data. The drive also comprises an adjustable timing reference for each of the one or more converters; each timing reference is for adjustment based on an expectation of a frequency of a clock in the respective signal of each converter. The drive further comprises a locking loop circuit for each of the one or more converters; the locking loop circuit is for tracking the respective system clock of each converter to the clock in the respective signal. The drive further comprises logic operable to estimate a frequency of each system clock, to determine a respective comparison value between the estimated frequency of each system clock and the expectation of the frequency of the clock in the respective signal of each converter, and to provide for adjustment of each expectation if one or more of the comparison values exceeds a predetermined first threshold.

### BRIEF DESCRIPTION OF THE DRAWINGS

For describing aspects and examples herein, reference is made to the accompanying drawings in the following description.

FIG. 1 illustrates a drive in which exemplary circuits and methods described herein may be used;

FIG. 2 illustrates an exemplary circuit for recovery of a clocking signal and data from a signal generated in the drive of FIG. 1;

FIG. 3 illustrates a locking loop circuit portion of the circuit of FIG. 2;

FIGS. 4a-c illustrate correction of a timing reference to differences in frequency of a clocking signal from an expected frequency of the clocking signal; and

FIG. 5 illustrates a method for adjusting the expected frequency of the clocking signal to reduce detected differences between an estimated frequency of the clocking signal and the expected frequency of the clocking signal.

### DETAILED DESCRIPTION

The following description is presented to enable a person of ordinary skill in the art to make and use various aspects of the inventions. Descriptions of specific materials, techniques, and applications are provided only as examples. Various modifications to the examples described herein will be readily apparent to those skilled in the art, and the general principles defined herein may be applied to other examples and applications without departing from the spirit and scope of the inventions. For example, aspects and examples described herein may be employed in a variety of storage devices and drives. Circuits and devices incorporating aspects discussed herein may be designed and may operate in a number of ways. Exemplary subject matter provided herein is for illustrating various inventive aspects, rather than for limiting applicability of any portion of that subject matter to any illustrated device.

One of ordinary skill in the art would understand that teachings related to any single inventive aspect herein may be adapted to a variety of implementations. Also, it would be understood that certain components have been separately identified herein, but such identification does not imply that such components must be separately formed from other components. Similarly, components identified herein may be divided into sub-components in other designs.

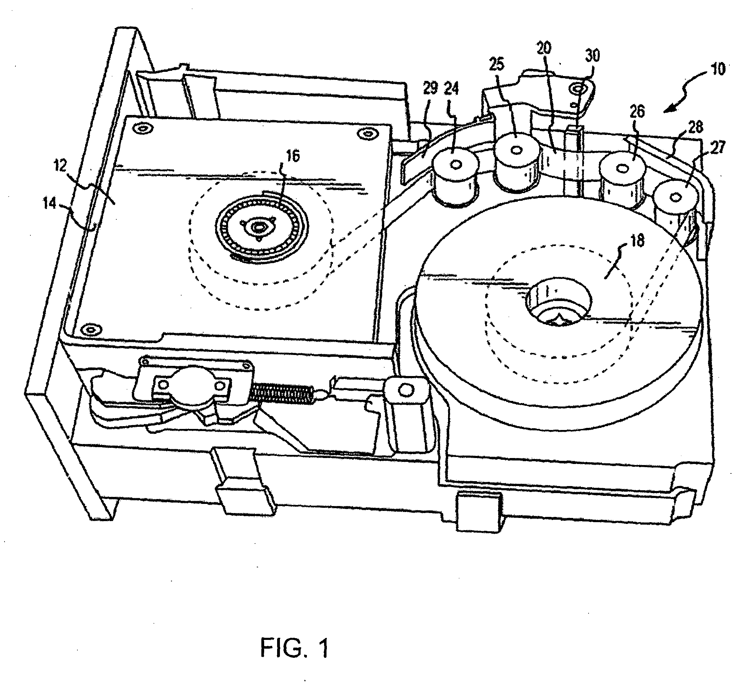

FIG. 1 illustrates a cut-a-way view of an exemplary magnetic tape drive 10 in which exemplary locking loop circuits as described herein may be used. This tape drive 10 example is provided to facilitate description and provide context for aspects of locking loop circuits described herein. It is understood that locking loop circuits and associated methods described herein may be applied in various drives, and other applications in which clock recovery from a signal is required.

Tape drive 10 includes a tape cartridge 12 inserted into a receiver 14. Tape drive 10 includes a motor (not shown) which drives a cartridge supply reel 16 and moves tape 20 at a particular speed (e.g., 120 inches per second or more). Tape drive 10 may also include a second motor (not shown) which drives a take-up reel 18. Tape 20 may be driven in either a forward direction or a reverse direction to write data onto or read data from the tape as controlled by a motor controller circuit (not shown in FIG. 1, but typically provided on one or more printed circuit boards). The controller may also be adapted for controlling magnitudes of read/write currents passed through head 30, e.g., to select particular read/write elements for particular data formats and data tracks. Tape 20 is guided through tape drive 10 by a plurality of tape guide assemblies 24-29 between the take-up reel 18 and the cartridge 12 and past head 30.

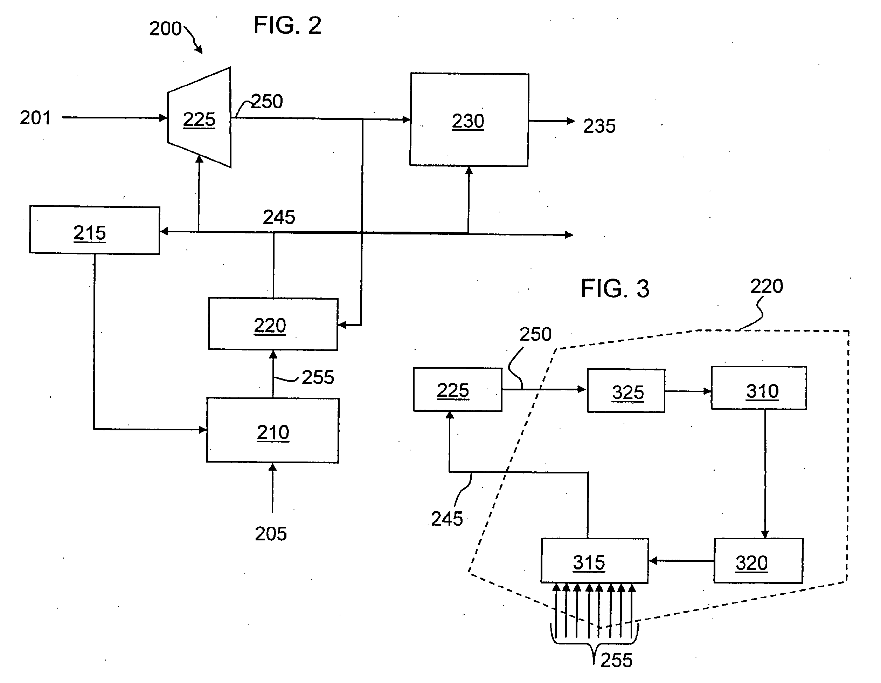

Additionally, the tape drive 10 of FIG. 1 includes a circuit 200 (FIG. 2) for interpreting the signal recovered from the storage media by head 30, which the tape drive 10 is adapted to read. For many data storage applications, the signal read from the storage media includes a clocking signal encoded with data in any of a variety of formats. The clocking signal provides timing information such that the data can be accurately sampled to avoid missing and/or double counting bits. Thus, for recovery of the data from the signal, it is usually required to recover the encoded clocking signal so that that there is a known timing for the recovered data. In some examples of tape drive 10, head 30 may recover multiple signals from the storage media, where each signal typically includes a cocking signal encoded with data.

Recovery of the clock signal typically involves tracking the clocking signal through frequency and phase jitter from a variety of causes. Such causes may include variations in the rate at which the data was stored on the media caused by machining tolerances, precision of motor speed control, and other variations amongst and between drive components, temperature variations, degradation of components, or other sources of jitter. Jitter may also be added to the clock/data signal by the tape drive reading the storage media for many of the same reasons. Thus, it is important to be able to track the clocking signal through this jitter.

Some methods of tracking encoded clock signals involve use of locking loop circuits that operate by feedback mechanisms to match a frequency and phase of a generated clock to the clock encoded with the data. Such locking loop circuits include phase locked loops (PLL) and delay locked loops (DLL). Some locking loop circuits are implemented with techniques associated with both phase and delay locked loops. The term locking loop circuit is used herein to emphasize that aspects disclosed herein may be used in any of a variety of circuits that track clocking signals in mixed clock/data signals, including PLL and DLL circuits.

Turning to FIG. 2, circuit 200 for recovering a clocking signal from a clock/data signal is illustrated. The clock/data signal is received at input 201 of converter 225. Converter 225 may be an analog to digital converter with a given bit precision, for example 6 bits. The converter 225 may be synchronized with a system clock 245. Thus, converter 225 may convert an analog clock/data signal received at input 201 to quantized digital approximations taken at intervals determined by system clock 245, and outputted to quantized output 250. The quantized digital approximations from output 250 may be viewed as a data stream.

Characteristics of system clock 245, such as frequency and phase, are controlled by locking loop circuit 220. Locking loop circuit 220 receives the quantized output and estimates the clocking signal. The locked loop circuit 220 tracks the system clock 245 to the estimation of the clocking signal. Usually, before the locked loop circuit 220 can track the system clock 245 to the estimation of the clocking signal, the locked loop circuit 220 must achieve a lock (i.e., detect and initially bring the system clock 245 into approximate tracking with the clocking signal). The system clock 245 is also used by data detector 230 to extract a binary output 235 timed to the system clock from the quantized digital approximations of output 250. Thus, it is often the case that both proper sampling of the analog signal and subsequent conversion of the quantized output depend on a system clock accurately tracked to the clocking signal.

The locking loop circuit 220 uses a timing reference 255, which provides the locking loop circuit 220 an indication of an expected frequency of the clocking signal to be recovered from the clock/data signal. In practice, the actual frequency of the clocking signal recovered may initially be different from this expected frequency, and the actual frequency may vary with time. The timing reference 255 may include a reference clock. In this example, timing reference 255 provides a plurality of phases of the reference clock so that the locking loop circuit 220 may use the phases as a basis for interpolation to align the system clock edges with the clocking signal being recovered.

The timing reference 255 of the present example is provided by a programmable synthesizer 210 having one or more registers that control multiplication or division ratios of a global clock input 205. The timing reference 255 may also contain other features such as an ability to control when a change in the reference frequency is to be effected. Such a feature may be useful for reasons to be discussed herein.

To allow the locking loop circuit 220 to reliably achieve a lock on the clocking signal, the timing reference 255 usually must be within a predetermined lock-in range of the clocking signal. This predetermined lock-in range is usually selected based on various design criteria that may include settling time, ability to track the clocking signal once lock has been achieved, operating ranges of various sorts, process and chip integration considerations, and the like. Often, designing a wider lock-in range into locking loop circuit 220 adversely affects other performance criteria.

Assuming that the locking loop circuit has achieved a lock on the clocking signal, and is tracking the system clock 245 to the clocking signal, logic 215 estimates the frequency of the system clock 245 (which, since system clock 245 is tracked to the clocking signal, is a way to estimate the frequency of the clocking signal itself). Logic 215 may estimate the frequency by counting detected transitions over a known time interval, or by another acceptable frequency estimating means.

The logic 215 compares the estimated frequency of the system clock 245 with the expected frequency (the frequency of timing reference 255). In this example, because logic 215 controls the expected frequency through manipulation of the one or more registers in programmable synthesizer 210, the frequency of the timing reference is "known" by logic 215 and need not be measured. If the expected frequency differs from the estimated frequency by more than predetermined thresholds, the logic identifies an appropriate correction for the expected frequency. For example, a difference greater than 5% may be enough to require correction, or a difference in 5kHZ may be enough to correct. Such thresholds will typically be selected based on the frequency of the clocking signal, how much lock-in range is available, and how much variation is likely in the frequency of the clocking signal.

After an appropriate correction is identified, the correction is applied to programmable synthesizer 210, and propagated to timing reference 255 at an appropriate point. In the present example, the appropriate correction may be identified for aligning, as closely as possible, the expected frequency with the estimated system clock 245 frequency.

For simplicity, the above examples and related description described clock recovery from a single signal. In other examples, a clock may be recovered from each of a plurality of signals, such as signals generated based on reading a plurality of tracks from a given storage medium. In one such example, circuit 200 may be replicated for each of the plurality of signals from which a clock is to be recovered. Portions of circuit 200 may also be shared for recovering clocks from the plurality of signals, depending on implementation. The operation of each circuit 200 may be substantially in accordance with the operation described above, and further features may also be implemented as described below.

One such feature helps prevent erroneous updating of the expected frequency of one or more of the plurality of signals by determining whether the clock recovered from those signals is substantially in accordance with clocks recovered from other signal(s) of the plurality. A situation where such a feature may be useful is where a defect in storage media, or some other transient noise, causes a temporary diversion in the estimated frequency of a clock being recovered from a signal. If a correction to an expected frequency of the clock were based on this temporary diversion, an error would be propagated. Instead, a correction may be based on an estimated frequency of a clock being recovered from another signal.

For example, a system for recovering a clock from each of a first signal and a second signal may include logic 215 (which may be shared partially or entirely in clock recovery from the first signal and the second signal). Logic 215 may be adapted to compare an estimated frequency of a system clock 245 associated with each of the first signal and the second signal with a respective expected frequency of a clock in each signal. Where a comparison value between each estimated frequency of each system clock 245 and a frequency of the respective clock exceeds a first threshold, an adjustment may be made. If that comparison value also exceeds a second threshold then the adjustment may be made on a comparison value from a different system clock/expectation comparison.

For example, if a comparison value between the estimated frequency of the system clock for the first signal indicates a 5% difference between the expected frequency of the clock in the first signal, then a determination to adjust the expectation may be made. However, if the comparison value indicates a 20% difference between the estimated frequency and the expected frequency then the adjustment may be made based on a comparison value between the estimated frequency of the system clock for the second signal and the expected frequency of the clock in the second signal.

In such an example, where some transient noise causes a locking loop circuit 220 tracking the clock in one of the first signal and the second signal to diverge, the system may ignore such diversion in favor of what is apparently a less divergent estimate of the frequency of that clock. Of course, where no comparison value is substantially different from another, an update to any expectation may be based on a difference between any estimated and expected frequency, and not solely on a difference between the estimated and expected frequency of the clock in that signal.

Other exemplary systems include a system for recovering clocks from three or more signals. Such a system may use an estimated frequency closest to its respective frequency for updating all estimated frequencies, exclude an estimated frequency most different from its expected frequency and average the others, average all the estimated frequencies, any combinations of such steps, or other procedures used to establish what is likely to be a more accurate estimate than an apparently divergent measured estimated frequency. Such exemplary systems may exclude use of estimated frequencies differing by more than a threshold amount from respective estimated frequencies for updating expected frequencies. The threshold amount may be a percentage deviation from an expected frequency, an absolute deviation, or the threshold amount may be based on the deviations between the estimated and expected frequencies of the clocks in the other signals.

For some applications, the clock/data signal received at input 201 may contain data that is separated into blocks. For example, in the tape drive of FIG. 1, the tape is usually encoded such that data is encoded on the tape in blocks, where each block is separated by some distance on the tape. When the tape is read for generating the clock/data signal by moving the tape over a read head, the resulting clock/data signal includes blocks of data separated from each other by some amount of time. During the time between a block of data and a succeeding block of data, there is often no clocking signal for the locking loop circuit 220 to track. In such instances, locking loop circuit 220 may drift, or it may be reinitialized.

In the present example where the clock/data signal includes blocks of data, the logic 215 is operable to estimate the frequency of system clock 245 multiple times during each block. The logic 215 uses the estimate of the system clock 245 frequency taken closest to an end of a given block of data as a basis for comparing the frequency of the system clock with the expected frequency. The logic determines whether the estimate of the system clock 245 frequency differs by more than the predetermined thresholds, identifies an appropriate correction, and applies that correction to the programmable synthesizer 210 before a beginning of a succeeding block of data in the clock/data signal. By applying the correction after an end of one data block and before a beginning a succeeding data block, the logic 215 reduces potential for disruption or other discontinuity in timing reference 255.

In the present example, the logic 215 implements corrections to the expected frequency (and hence to timing reference 255) by updating registers. In other examples, a frequency of global clock 205 may be changed. In other examples, both global clock 205 and programmable registers may be updated. Also, the present example calls for only adjusting the expected frequency where there is at least a certain minimum difference (a first threshold) between the estimated system clock 245 frequency and the expected frequency. In other examples, the logic 215 may always update the expected frequency to approximate as closely as possible the estimated system clock 245.

In the present example, the logic 215 is operable to apply a correction to the expected frequency to align the expected frequency with the last approximation of the system clock 245 frequency. This configuration relies on a correlation between clocking signal frequency between blocks of data. In other examples, other algorithms may be used to determine an appropriate correction to the expected frequency; these algorithms may attempt to account for other factors in predicting an expected frequency of the clocking signal in the succeeding data block and arriving at an appropriate correction. For example, algorithms may include a rate of change of the estimated system clock 245.

In examples, the logic 215 is estimating a system clock frequency tracked to each clock in a plurality of signals, and forming a comparison value between each estimated system clock frequency and a respective expected frequency of the clock in that signal. In such examples, the logic 215 may perform various comparisons between and among the comparison values, and comparison values deviant by more than a second threshold from other comparison values may be deemed erroneous (e.g., affected by transient noise) and not used as a basis for updating an expectation of the frequency of the clock in that respective signal.

In any such examples, the logic 215 may include a lookup table for mapping an appropriate correction to the expected frequency to particular register values for writing to the programmable synthesizer 210. The logic may also include a lookup table containing information regarding thresholds that govern when a correction to the expected frequency is required. These thresholds may be updatable for particular application, and such updates may be based on empirical evidence regarding clocking signal behavior.

For example, as components degrade, or as operating conditions change, empirical evidence may show that threshold updates are required. Engineering tolerances of various components may also affect choice of and updating of thresholds. The algorithms used to determine an appropriate correction may also be updatable, either by updating various factors used in the algorithms, or by changing the algorithm itself. Any thresholds and other bases of comparison described herein may be updatable. The logic may be implemented in an FPGA, an ASIC, or by using a programmable processor with associated software, or any combination of fixed and programmable logic or processors, as one of ordinary skill in the art would comprehend.

FIG. 3 illustrates an implementation of locking loop circuit 220, and related components. Quantized output 250 of the converter 225 is received by phase detector 325, the output of which is filtered by loop filter 310, the loop filter output is input to the integrator 320, and the output of integrator 320 is input to the phase interpolator 315. The phase interpolator receives eight phases of the reference clock in the timing reference 255. Based on input received from the integrator 320, the phase interpolator outputs system clock 245 tracked to the frequency and the phase of the clocking signal detected and processed by the other functional units. A variety of references regarding design of phase and delay locked loops are available, and one of ordinary skill in the art would be able to apply the teachings herein either to original PLL and DLL designs or to adapt existing PLL or DLL parts with these teachings. For example, Texas Instruments makes a read channel, part no. SP3416AAA0DGG, which may readily be adapted based on the teachings herein. This part includes all the elements of FIG. 2 except the logic 215 and other not illustrated supporting circuitry. Other implementations may integrate the logic 215 in the same package or monolithically with other components. Other physical divisions of these components are realizable by one of ordinary skill in the art.

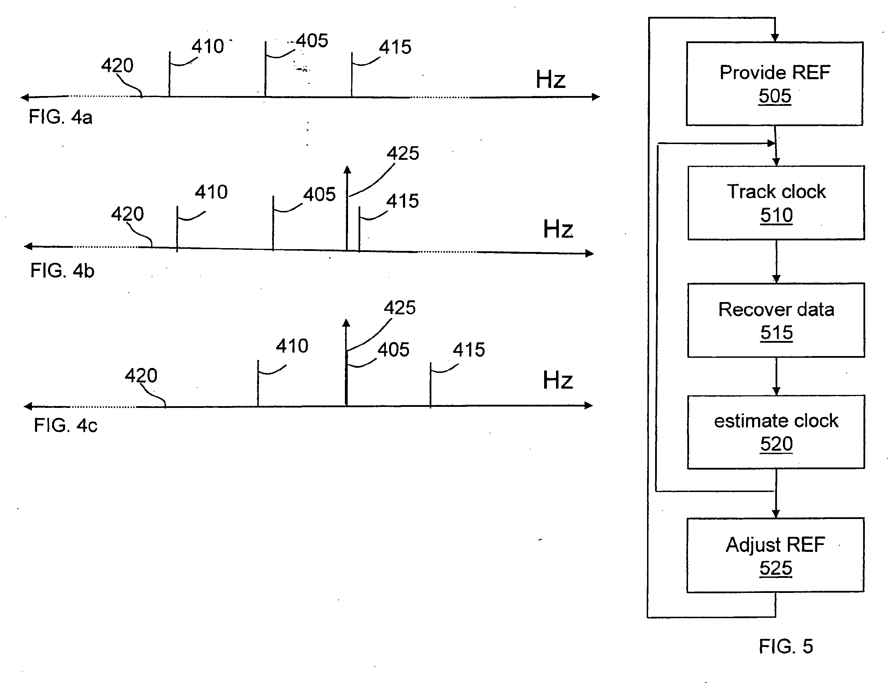

FIG. 4a-c illustrate how the locking loop circuit 220 and associated circuitry may function by illustration of a frequency axis 420 on which is superimposed an expected frequency 405, a lower lock-in frequency 410, and an upper lock-in frequency 415. The lower lock-in frequency 410 and the upper lock-in frequency 415 change with changes in the expected frequency 405. For example, the lower lock-in frequency may be 1% below the expected frequency 405 and the upper lock-in frequency may be 1% above the expected frequency 405. The lower 410 and the upper 415 lock-in frequencies may be non-symmetrical about expected frequency 405.

For proper lock of the clocking signal, the frequency of the clocking signal should be within the lower lock-in frequency 410 and the upper lock-in frequency 415. FIG. 4b illustrates that the estimated system clock 245 frequency 425 is higher than the expected frequency 405, but the frequency 425 is lower than upper lock-in frequency 415, and the locking loop circuit 220 should be able to lock onto and track the clocking signal. This example assumes that the frequency 425 of FIG. 4b is the last frequency estimate of the system clock 245 before the end of a block of data. FIG. 4c thus illustrates that the expected frequency 405 is updated to reduce the comparison value between the expected frequency 405 and the estimated system clock 245 frequency 425.

The conceptual process illustrated in FIGS. 4a-c is further illustrated in the method of FIG. 5. In FIG. 5, timing reference 255 is provided to the locking loop circuit 220. In step 510, the locking loop circuit 220 tracks the clocking signal and data is recovered by the data detector 230 in 515. While the clocking signal is tracked, and data is recovered, the logic 215 estimates 520 the frequency of the system clock 245 which is output from the locking loop circuit 220 as it tracks the clocking signal. During a given block of data, steps 510-520 may repeat. The logic 215 provides for the adjustment 525 of the expected frequency for propagation to the timing reference 255 after the end of the block. The process repeats with providing 505 the timing reference, where the timing reference reflects the adjustments to the expected frequency. As discussed above, the adjustments are usually made after the end of the block and before a beginning of the succeeding block.

A system recovering a clock from each of a plurality of signals may implement these method steps in substantially similar form with appropriate duplication of steps for each signal. Additional steps may be included, especially with regard to adjustment 525. The adjustment 525 step may include determining whether one or more of the estimated frequencies for each clock differs too much from its respective expected frequency, and an appropriate adjustment to the expected frequency of each clock may be determined based on the other estimated frequencies or any information derivable from the other signals, as described above.

Other modifications and variations would also be apparent to those of ordinary skill in the art from the exemplary aspects presented. Additionally, particular examples have been discussed and how these examples are thought to address certain disadvantages in related art. This discussion is not meant, however, to restrict the various examples to methods and/or systems that actually address or solve those disadvantages.

## Claims

1. A method, comprising:
causing provision of a first timing reference to a first locKmg loop circuit, the first timing reference set based on an expectation of a frequency of a clocking signal;
estimating a current frequency of the clocking signal; and
updating the expectation of the frequency of the clocking signal based on the estimated current frequency.

2. The method of claim 1, wherein the clocking signal is encoded in a data stream, the data stream includes a first block of data, the clocking signal is encoded in the first block, approximating the current frequency includes approximating the current frequency at least proximate an end of the first block, and updating the expectation is performed after the end of the first block and before a beginning of a second block of data.

3. The method of claim 2, further comprising approximating the current frequency at least proximate an end of the second block, and further updating, before a beginning of a third block of data, the expectation of the clocking signal.

4. The method of claim 2, wherein the timing reference is set based on the updated expectation before the beginning of the second block of data.

5. The method of claim 1, wherein the timing reference includes a reference clock, and a frequency of the reference clock is initially within a range of the expectation of the frequency of the clocking signal.

6. The method of claim 1, wherein the timing reference includes a reference clock, and updating the expectation includes providing for the adjustment of the frequency of the reference clock.

7. The method of claim 6, wherein the reference clock is generated by a programmable synthesizer, and the adjustment of the frequency of the reference clock is provided for by altering contents of one or more registers associated with the programmable synthesizer.

8. The method of claim 1, wherein the locking loop circuit is operable to output a system clock tracked to the clocking signal, and the approximation of the current frequency of the clocking signal is an approximation of a frequency of the system clock.

9. The method of claim 8, wherein the timing reference includes a reference clock, and updating the expectation includes providing for the adjustment of the frequency of the reference clock..

10. The method of claim 1, wherein updating the expectation includes determining whether a comparison value between the current frequency and the expectation of the frequency of the clocking signal exceeds a predetermined threshold, and identifying an update for decreasing the comparison value.

11. The method of claim 10, wherein the timing reference includes a reference clock, and identifying the update for decreasing the comparison value includes determining an updated frequency for the reference clock.

12. The method of claim 1, wherein the clocking signal is derived from a data stream that is input to the first locking loop circuit.

13. The method of claim 1, wherein the clocking signal is derived from a data stream that is input to a second locking loop circuit.

14. The method of claim 13, wherein the current frequency of the clocking signal is estimated by estimating a current frequency of a system clock output by the second locking loop circuit.

15. The method of claim 13, further comprising determining that estimating the current frequency of the clocking signal by estimating a current frequency of a system clock output by the first locking loop circuit is likely to be less accurate than estimating the current frequency of the system clocking signal by estimating a current frequency of a system clock output by the second locking loop circuit.

16. The method of claim 1, wherein the clocking signal is one of a plurality of clocking signals generated by a plurality of locking loop circuits, and a current frequency of each of the clocking signals is estimated, and updating the expectation of the frequency of the clocking signal includes selecting one or more of the estimated current frequencies as a basis for the update.

17. A drive for reading storage media, comprising:
one or more converters clockable by a respective system clock and for receiving a respective signal and outputting a respective quantized stream of data;
an adjustable timing reference for each of the one or more converters, each timing reference for adjustment based on an expectation of a frequency of a clock in the respective signal of each converter;
a locking loop circuit for each of the one or more converters, the locking loop circuit for tracking the respective system clock of each converter to the clock in the respective signal; and
logic operable to estimate a frequency of each system clock, to determine a respective comparison value between the estimated frequency of each system clock and the expectation of the frequency of the clock in the respective signal of each converter, and to provide for adjustment of each expectation where the respective comparison value exceeds a predetermined first threshold.

18. The drive of claim 17, wherein an adjustment for each expectation is selected based on the respective comparison value of that expectation.

19. The drive of claim 17, wherein the logic is further operable to determine whether basing an adjustment for each expectation on the respective comparison value of that expectation would apparently cause unacceptable divergence of that expectation from the frequency of the clock in the respective signal, and to base an adjustment for each such expectation on a comparison value apparently resulting in a less divergent expectation.

20. The drive of claim 17, wherein if a respective comparison value exceeds a predetermined second threshold, an adjustment for that expectation is selected based on a comparison value not exceeding the predetermined second threshold.

21. The drive of claim 17, wherein the respective quantized streams of data are each interpretable as a series of data blocks, the logic is operable for estimating the frequency of each respective system clock for each respective data block and to provide for each adjustment after an end of each respective data block and before a beginning of a succeeding data block.

22. The drive of claim 20, wherein each adjustment is based on the respective comparison value of that expectation so long as the respective comparison value does not exceed a predetermined second threshold.

23. The drive of claim 21, wherein the predetermined second threshold is based on a comparison of the respective comparison values.

24. The drive of claim 20, wherein each respective locking loop circuit is operable to detect and track each clock encoded in each signal so long as the frequency of that clock is within a predetermined lock-in range of a base frequency of each timing reference, and each adjustment is provided for maintaining each expectation of the frequency of the clock encoded in each signal within the lock-in range of the frequency of each system clock in the succeeding data block.

25. A circuit, comprising logic operable to estimate a frequency of a first system clock, the first system clock trackable by a locking loop circuit to a clock encoded in a first signal, the locking loop circuit operable to receive a timing reference adjustable based on an expected frequency of the clock encoded in the first signal, the logic further operable to adjust the expected frequency upon determination that a first comparison value between the frequency of the first system clock and the expected frequency exceeds a predetermined first threshold.

26. The clock recovery circuit of claim 25, further comprising:
a converter clockable by the first system clock, the converter operable to output a digitized signal based on the first signal, the clock encoded in the first signal trackable by the first locking loop circuit using the digitized signal, and data separatable into a series of data blocks is recoverable from the digitized signal, wherein
the logic is operable to estimate the frequency of the first system clock and to determine whether the comparison value between the estimated frequency of the first system clock and the expected frequency is greater than the predetermined first threshold for each of the series of data blocks, and to adjust after an end of each of the data blocks and before a beginning of a respective succeeding data block.

27. The clock recovery circuit of claim 26, wherein the logic is operable to repeatedly estimate the frequency of the first system clock for each data block, and to select respective adjustments based on an estimate taken closest to the end of each of the data blocks.

28. The clock recovery circuit of claim 25, wherein the logic is operable to adjust based on the first comparison value unless the comparison value exceeds a second predetermined threshold, whereupon the logic is operable to adjust.based on a second comparison value between a second system clock and an expectation of a frequency of a clock in a second signal.

29. The clock recovery circuit of claim 25, wherein the predetermined first threshold is a fraction of a lock-in range of the locking loop circuit.
